(19)

Europäisches Patentamt

European Patent Office

Office européen des brevets

(11)  **EP 4 404 458 A1**

(12)  **EUROPEAN PATENT APPLICATION**

(43) Date of publication:
    **24.07.2024  Bulletin 2024/30**

(21) Application number: **24151466.0**

(22) Date of filing: **11.01.2024**

(51) International Patent Classification (IPC):
    *H03F 1/22* (2006.01)    *H03F 1/02* (2006.01)
    *H03F 1/30* (2006.01)    *H03F 1/56* (2006.01)
    *H03F 3/195* (2006.01)   *H03F 3/24* (2006.01)
    *H03F 3/21* (2006.01)    *H03F 3/30* (2006.01)

(52) Cooperative Patent Classification (CPC):
    **H03F 1/223; H03F 1/0288; H03F 1/301;**
    **H03F 1/307; H03F 1/565; H03F 3/195; H03F 3/211;**
    **H03F 3/245; H03F 3/3022;** H03F 2200/451;
    H03F 2200/61; H03F 2203/30084;
    H03F 2203/30117

(84) Designated Contracting States:
    **AL AT BE BG CH CY CZ DE DK EE ES FI FR GB**
    **GR HR HU IE IS IT LI LT LU LV MC ME MK MT NL**
    **NO PL PT RO RS SE SI SK SM TR**
    Designated Extension States:
    **BA**
    Designated Validation States:
    **KH MA MD TN**

(30) Priority:  **13.01.2023  US 202363479788 P**
        **13.01.2023  US 202363479790 P**
        **13.01.2023  US 202363479787 P**
        **15.05.2023  US 202363502268 P**
        **30.06.2023  US 202363511352 P**
        **17.07.2023  US 202363513974 P**
        **20.09.2023  US 202363539384 P**
        **29.12.2023  US 202318400433**

(71) Applicant: **Qorvo US, Inc.**
    **Greensboro, NC 27409 (US)**

(72) Inventors:
    • **Shahverdi, Amin**
      **Richardson, Texas 75081 (US)**
    • **Klemmer, Nikolaus**
      **Richardson, Texas 75081 (US)**
    • **Hajji, Rached**
      **Richardson, Texas 75081 (US)**
    • **Reese, Elias**
      **Richardson, Texas 75081 (US)**
    • **Landon, Thomas**
      **Richardson, Texas 75081 (US)**
    • **Ascencio, Hugo**
      **Richardson, Texas 75081 (US)**

(74) Representative: **D Young & Co LLP**
    **3 Noble Street**
    **London EC2V 7BQ (GB)**

(54)  **METHODS AND TECHNIQUES TO IMPROVE STABILITY OF CASCODE AMPLIFIERS AND ENHANCE LINEUP EFFICIENCY IN MULTI-STAGE POWER AMPLIFIERS**

(57)     A power amplifier cell (20) is disclosed having a first transistor (Q1) with a first terminal coupled to ground, a second terminal, and a first control terminal. A second transistor (Q2) has a third terminal coupled to the second terminal, a fourth terminal, and a second control terminal. Further included is a capacitor ($C_{BPY1}$) having a first plate coupled directly to the second control terminal and a second plate coupled to the ground. As such, there is no intervening inductor component coupled between the first plate and the second control terminal, leaving only parasitic inductance (LG2) between the first plate and the second control terminal. The capacitor ($C_{BPY1}$) has a capacitance sized to resonate with the parasitic inductance (LG2) at a resonant frequency substantially higher than a desired frequency of operation of the power amplifier cell (20).

FIG. 3

## Description

Related Applications

This application claims the benefit of provisional patent application serial number 63/513,974, filed July 17, 2023, and claims the benefit of provisional patent application serial number 63/479,788, filed January 13, 2023, the disclosures of which are hereby incorporated herein by reference in their entireties.

This application claims the benefit of provisional patent application serial number 63/539,384, filed September 20, 2023, and claims the benefit of provisional patent application serial number 63/511,352, filed June 30, 2023, and claims the benefit of provisional patent application serial number 63/502,268, filed May 15, 2023, and claims the benefit of provisional patent application serial number 63/479,790, filed January 13, 2023, and claims priority to provisional patent application serial number 63/479,787, filed January 13, 2023, the disclosures of which are hereby incorporated herein by reference in their entireties.

Field

The present disclosure relates to multi-stage power amplifiers employed in wireless communications.

Background

The efficiency of a power amplifier is a key parameter for any communication systems as power amplifiers in a transmitter unit consume a considerable part of the supplied power. Thermal conductivity of a package and solid-state material, insertion loss of matching networks, and load impedance are among the main parameters that establish efficiency of a single-stage power amplifier. Furthermore, in a multi-stage power amplifier, efficiency and gain of each stage determine the overall (lineup) efficiency of a power amplifier. For example, in a two-stage power amplifier, gain and efficiency of the final stage together with efficiency of first stage determine the lineup efficiency. While improving efficiency of each stage has been explored, gain (of last stage, especially) has been overlooked given that there are not too many options available (such as engineering solid-state material).

Summary

Particular aspects are set out in the appended independent claims. Various optional embodiments are set out in the dependent claims.

Disclosed herein are methods and techniques to improve the gain of the final stage amplifier (in a two-stage power amplifier) and eventually lineup efficiency, without sacrificing other relevant parameters such as output power and stability.

A power amplifier cell is disclosed having a first transistor with a first terminal coupled to ground, a second terminal, and a first control terminal. A second transistor has a third terminal coupled to the second terminal, a fourth terminal, and a second control terminal. Further included is a capacitor having a first plate coupled directly to the second control terminal and a second plate coupled to the ground. As such, there is no intervening inductor component coupled between the first plate and the second control terminal, leaving only parasitic inductance between the first plate and the second control terminal. The capacitor has a capacitance sized to resonate with the parasitic inductance at a resonant frequency substantially higher than a desired frequency of operation of the power amplifier cell.

In some embodiments, the first transistor and the second transistor are field-effect transistors. In these embodiments, the first current terminal and the third current terminal are source terminals, while the second current terminal and the fourth current terminal are drain terminals. Moreover, in these embodiments, the first control terminal and the second control terminal are gate terminals. The fixed voltage node is typically ground.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

Brief Description of the Drawing Figures

The accompanying drawing figures incorporated in and forming a part of this specification illustrate several aspects of the disclosure and, together with the description, serve to explain the principles of the disclosure.

FIG. 1 is a diagram showing a related-art two-stage power amplifier.

FIG. 2A is a graph showing a lineup efficiency of a sample two-stage amplifier for the lineup efficiency vs. final stage gain when $\eta_2 = 55\%$ and $\eta_1$ decreases from 16% to 13% as $G_2$ increases.

FIG. 2B is a graph showing a lineup efficiency of a sample two-stage amplifier for the lineup efficiency vs. first stage efficiency when $\eta_2 = 55\%$ and $G_2 = 14$ dB.

FIG. 3 is a diagram showing a cascode power amplifier that is configured to provide relatively higher gain than is typical of similarly structured power amplifiers.

FIG. 4A is a diagram showing a two-stage power amplifier with a final stage Doherty power amplifier (DPA) using a cascode field-effect transistor (FET) and a first stage single-ended power amplifier using a common source FET in which there is no inverted DPA in the final stage.

FIG. 4B is a diagram showing a two-stage power amplifier with a final stage DPA using a cascode FET and a first stage single-ended power amplifier using a common source FET in which there is an inverted DPA in the final stage.

FIG. 5 is a diagram showing a FET with a cascode structure at each unit cell, and in each unit cell, FET1 and FET2 are common source and common gate FETs, respectively.

FIG. 6A is a diagram showing a FET with a cascode structure at each unit cell and a parasitic inductance that is minimized by bypass capacitors.

FIG. 6B is a diagram showing a FET with a cascode structure at each unit cell wherein a stabilizing resistor is added in front of the parasitic inductance that is minimized by bypass capacitors.

FIG. 7A is a Smith chart showing $S_{22}$ of two cascode FETs at 0.1 GHz to 20 GHz that compares $S_{22}$ of an embodiment shown in FIG. 6A (dashed line) with the $S_{22}$ of the embodiment shown in FIG. 5 (solid line).

FIG. 7B is a Smith chart showing $S_{22}$ of two cascode FETs at 2 GHz to 8 GHz. Dashed line: $S_{22}$ of the layout as shown in FIG. 6A. Solid line: $S_{22}$ of the layout as shown in FIG. 5.

FIG. 8A is a simplified schematic of a pair of adjacent unit cells in accordance with the present disclosure.

FIG. 8B is a layout diagram of the pair of adjacent unit cells schematically depicted in FIG. 8A.

FIG. 9 is a diagram showing how the disclosed power amplifier cell may interact with user elements such as wireless communication devices.

Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

The present disclosure pertains to increasing lineup (overall) efficiency in power amplifiers, including power amplifier modules and integrated circuits, which is commonly perceived as a significant requirement for designing transmitter units for communication and radar applications. Methods and techniques disclosed herein result in higher lineup efficiency, at least 4 percentage points in one embodiment, without modifying solid-stage material or sacrificing other key performance parameters such as power and stability. The methods and techniques disclosed herein include, but are not limited to, the following considerations:

- Enhancing lineup efficiency of a two-stage (multi-stage in general) power amplifier module by implementing a high gain amplifier at final stage.
- Increasing the gain of an amplifier at the transistor level (e.g., field-effect transistor in gallium nitride technology) by implementing a cascode structure at each individual unit cell (finger) without sacrificing output power and stability.
- Resolving the instability of cascode amplifiers by implementing a transistor layout to minimize inductance between the gate and bypass capacitor in a common gate field-effect transistor and optimizing bypass capacitance.

In a multi-stage power amplifier, overall or lineup efficiency is determined by the efficiency and gain of each stage. Increasing the efficiency of each stage is a common practice that is often appropriate to be done to improve lineup efficiency of a power amplifier. However, the gain of the final stage plays an important role when the efficiency of each stage is limited by solid-state technology, packaging, or insertion loss of matching networks.

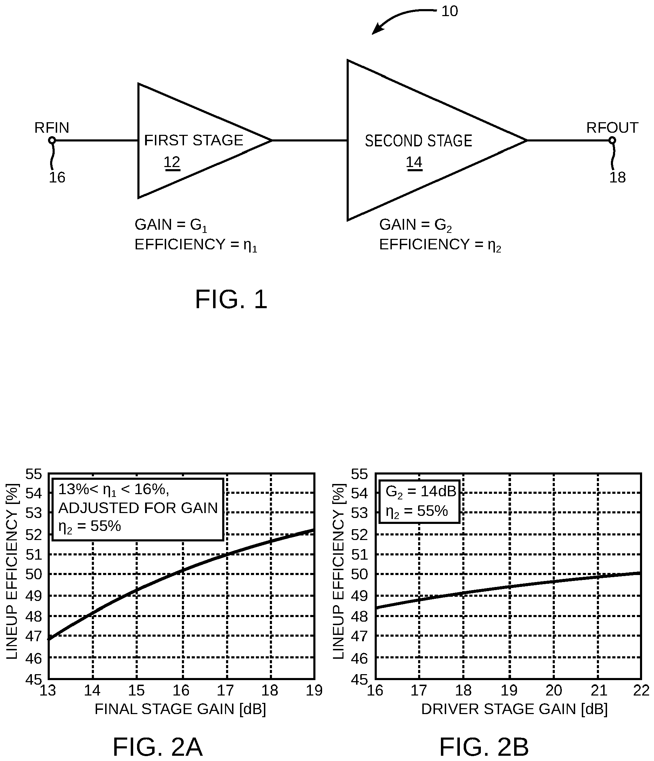

FIG. 1 is a schematic of a related-art two-stage power amplifier 10 that has a first stage 12 and a second stage 14 coupled between an RF input terminal 16, labeled RFIN, and an RF output 18, labeled RFOUT. In an example, the first stage 12 has a first stage gain G1 and a first stage efficiency $\eta_1$, and the second stage 14 has a second stage gain G2 and a second stage efficiency $\eta_2$.

In general, the lineup efficiency of the two-stage power amplifier 10 as shown in FIG. 1 can be simplified and is described in Equation 1:

$$\eta_{LU} = \frac{\eta_2}{1 + \frac{\eta_2}{G_2 \eta_1}} \qquad \text{Equation 1}$$

where $\eta_{LU}$ is lineup efficiency, $\eta_1$ is first stage efficiency, $\eta_2$ is second (final) stage efficiency, and $G_2$ is second stage gain. Based on this equation, $\eta_{LU}$ can be improved by increasing any or all three other parameters. In a specific case where $\eta_1$ and $\eta_2$ are constant, lineup efficiency can still be enhanced by increasing $G_2$.

In one example that is shown in FIG. 2A, a 5 dB increase in the second stage gain $G_2$ from 14 dB to 19 dB, is a 3.2 times increase in a linear scale. This results in 4 percentage points improvement in lineup efficiency from 48% to 52%. $\eta_2$ is 55% (0.55) and $\eta_1$ decreases from 16% to 13% as $G_2$ increases to consider expected lower efficiency for the first stage as the final stage gain increases. In another example that is shown in FIG. 2B, final stage efficiency is 55% and final stage gain is kept constant at 14 dB, which in this case is a

6 percentage points improvement in first stage efficiency from 16% to 22% and leads to 1.5 percentage points in lineup efficiency from 48.5% to 50%. These two examples clearly show the importance of implementing a high-gain, high-efficiency power amplifier in the final stage to achieve high lineup efficiency in the related-art two-stage power amplifier 10 and in general in other multi-stage power amplifiers.

For a typical common source (CS) amplifier or a typical common emitter (CE) amplifier, gain is mainly limited by solid-state technology, assuming proper source and load impedances are provided to a transistor making up the CS amplifier or CE amplifier. Therefore, it may be appropriate to implement other architectures to improve gain of the final stage of a multi-stage power amplifier.

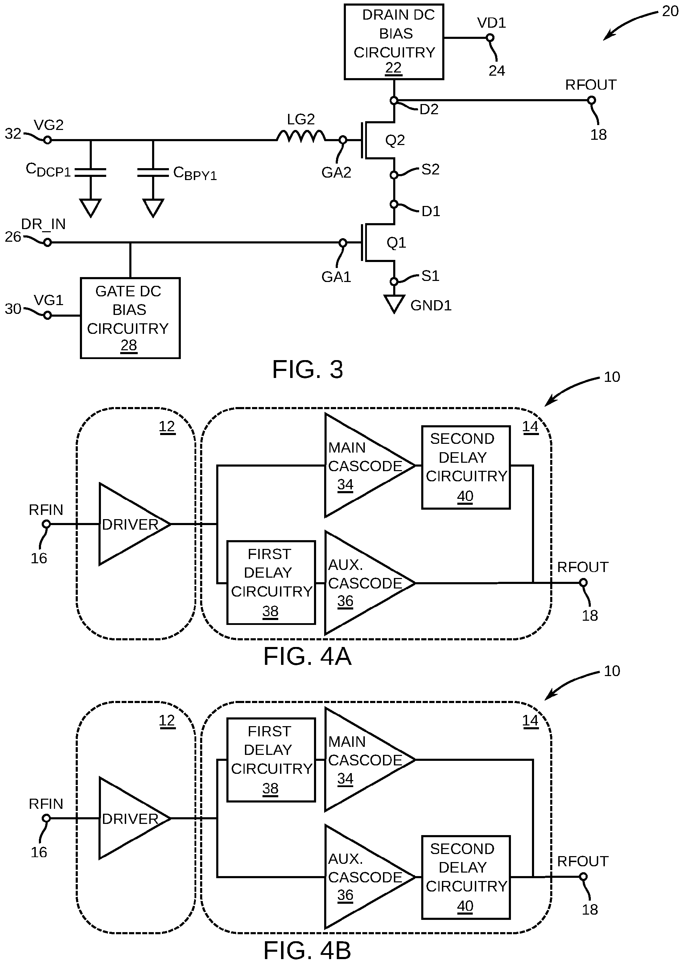

An embodiment of a cascode power amplifier 20 disclosed in accordance with the present disclosure is depicted FIG. 3. The cascode power amplifier 20 has high gain and is configured to deliver output power that is as high and as efficient as that of common source power amplifiers. The cascode structure of the cascode power amplifier 20 is realizable at the circuit or transistor level. As shown in FIG. 3, a first field-effect transistor (FET) Q1 and a second FET Q2 are coupled in a cascode structure between drain direct current (DC) bias circuitry 22 and a fixed voltage node GND1, which in this example is ground. The drain DC bias circuitry 22 is configured to generate drain bias from a drain voltage VD1 at a drain voltage terminal 24.

In this example embodiment, the first FET Q1 has a first source S1 coupled to the fixed voltage node and a first drain D1 coupled to a second source S2 of the second FET Q2. A first gate GA1 of the first FET Q1 is coupled to an interstage RF input 26 labeled DR_IN and to gate DC bias circuitry 28 that is configured to generate gate bias from a first gate voltage VG1 at a first gate voltage terminal 30. The second drain D2 of the second FET Q2 is coupled to the RF output 18, which is labeled RFOUT. A second gate GA2 of the second FET Q2 is coupled through a parasitic gate inductance LG2 to a second gate voltage VG2 at a second gate voltage terminal 32. At least one decoupling capacitor $C_{DCP1}$ is coupled between the second gate voltage terminal 32 and the fixed voltage node GND1. Additionally, a bypass capacitor $C_{BPY1}$ is also coupled between the second gate voltage terminal 32 and the fixed voltage node GND1.

In one example, the cascode transistor, formed by the first FET and the second FET, is a gallium nitride (GaN) high electron mobility transistor (HEMT) that has 3 dB to 5 dB higher gain compared with its common source counterpart designed in the same technology and with the same periphery, also known as gate periphery. Like all other transistors, the gain of a cascode transistor is determined by class of operation and varies as a function of source and load impedance that are provided to the transistor. Some of these conditions are described in the following examples.

In a first example embodiment, a cascode transistor, which in this embodiment is formed by the first FET Q1 and the second FET Q2, is biased in class AB, and load impedances are chosen in such a way as to maximize efficiency of the transistor at a specific power level (e.g., 3 dB to 4 dB lower than maximum power). Source impedances are chosen to maximize gain at the aforementioned load condition. These conditions are identical to a common method used to design main (carrier) amplifiers for a Doherty power amplifier (DPA) where the load impedance is called $Z_{MOD}$. In this case, the gain that a transistor can deliver is limited to the gain at the $Z_{MOD}$ load impedance, which is typically lower than maximum gain. However, the cascode transistor still provides 3 dB to 5 dB higher gain compared with a common source FET under the same load and bias conditions. For the application described in the first embodiment, $V_{G2}$ of the disclosed cascode power amplifier is configured to achieve maximum gain while output power and drain efficiency are kept close to output power and drain efficiency of a counterpart common source power amplifier with the same solid-state technology.

In a second example embodiment, the cascode transistor is biased in class AB and load impedances are chosen in such a way as to maximize efficiency of the transistor at maximum power level. These conditions are identical to a common method used to design main (carrier) amplifiers for a DPA, and the load impedance is called $Z_{OPT}$. In this case, gain that the transistor can deliver is limited to the gain (typically lower than maximum gain) at $Z_{OPT}$ load impedance. However, the cascode FET can still provide 3 dB to 5 dB higher gain compared with a common source FET under the same load and bias conditions.

In third example embodiment, the second FET is biased in class C and load impedances are chosen in such a way as to maximize efficiency of transistor at maximum power level. These conditions are identical to a common method used to design auxiliary (peaking) amplifiers for a DPA, and the load impedance is called $Z_{OPT}$. In this case, gain that the transistor can deliver is limited to the gain (typically lower than maximum gain) at $Z_{OPT}$ load impedance. However, a cascode FET can still provide 3 dB to 5 dB higher gain compared with a common source FET under the same load and bias conditions.

In other example embodiments shown in FIGS. 4A and 4B, a conventional common source FET makes up a single-ended power amplifier that is the first stage 12 in the two-stage power amplifier 10. Two cascode FETs are used in a Doherty power amplifier (DPA) configuration that includes a main cascode amplifier 34 and an auxiliary (AUX.) cascode amplifier 36 that makes up the second stage 14 in the two-stage power amplifier 10. In the example embodiment depicted in FIG. 4A has first delay circuitry 38 coupled between the first stage 12 and the auxiliary cascode amplifier 36, and second delay circuitry 40 coupled between the main cascode amplifier 34 and the RF output terminal 18. In contrast, the example embodiment of FIG. 4B has the first delay circuitry 38 coupled between the first stage 12 and the main cascode amplifier 34, and the second delay circuitry 40 coupled between the auxiliary cascode amplifier 36 and the RF output terminal 18. Other common circuitries like splitters, input matching networks, output matching networks, and load modulation networks are not shown for simplicity.

Second stage or final stage Doherty gain and efficiency at average output power is 18 dB and 55%, respectively, which are optimized by adjusting gate voltage of the common gate FET, in this embodiment VG2, in the cascode structure. Efficiency of the first stage 12 is 14% at average output power. Therefore, lineup efficiency of the two-stage power amplifier 10 is 52%, which is 4 percentage points higher than lineup efficiency of a two-stage power amplifier where all amplifiers are common source FETs with $\eta_1$ = 16%, $\eta_2$ = 55%, and $G_2$ = 14 dB.

In FIGS. 4A and 4B, the first stage 12 implemented using a single-ended common source FET can be replaced by a single-ended cascode FET to achieve higher lineup gain while the same lineup efficiency is maintained. In another example, the first stage 12 is a single-ended common source FET in FIGS. 4A and 4B and may be replaced by a DPA that uses common source or cascode FETs to achieve even higher lineup efficiency. In yet another example, the first stage 12 in the single-ended common source FET may be replaced by a balanced power amplifier that uses common source or cascode FETs to achieve better isolation between the first stage 12 and the second stage 14. Moreover, cascode FETs can be used in the second stage 14 or all stages of a multi-stage power amplifier, such as the two-stage power amplifier 10. Furthermore, first stage FET transistors in any examples described above may be replaced by heterojunction bipolar transistors (HBTs).

Further disclosed herein are cascode power amplifiers with enhanced stability. The cascode power amplifiers provide higher gain compared with common source power amplifiers or common emitter power amplifiers. However, higher gain in cascode power amplifiers results in instability issues that make implementing some embodiments relatively more challenging. Disclosed is a layout structure at the transistor level to resolve the stability issue of the cascode power amplifiers for a desired frequency band.

Returning to the cascode power amplifier 20 shown in FIG. 3, care should be exercised in designing the cascode structure in order to avoid any instability issues. A matching network (not shown in FIG. 3) may be needed between the first FET Q1 and the second FET Q2. One challenge is that there are parasitic inductances and capacitances between the first FET Q1 and the second FET Q2 and at the second gate GA2 (e.g., $L_{G2}$) which limit available options to improve stability.

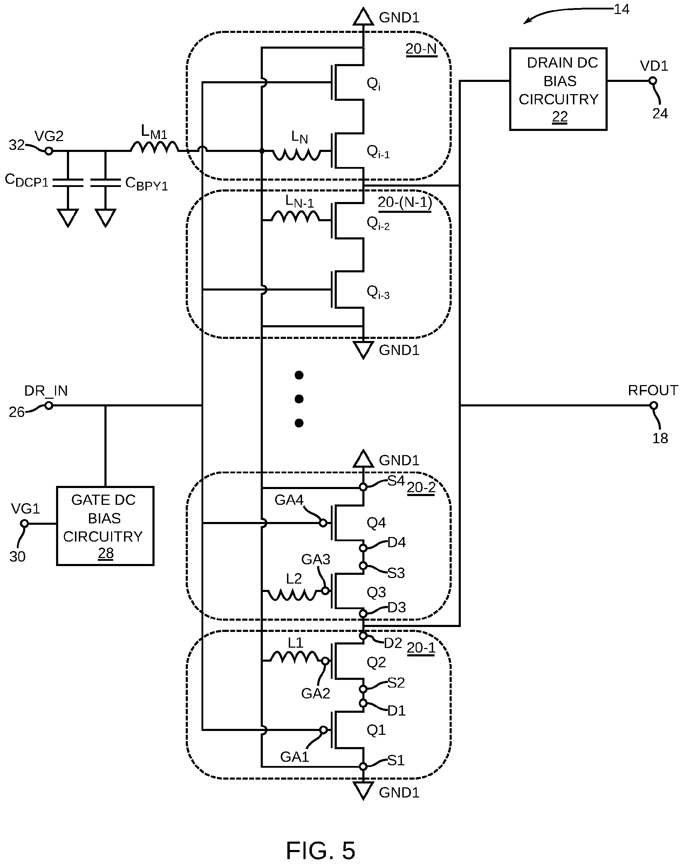

To eliminate a need for a matching network between the first FET Q1 and the second FET Q2 and to minimize undesirable effects of the parasitic inductances and capacitances, an improved cascode structure for the cascode power amplifier 20 can be realized as unit cells 20-1, 20-2, 20-(N-1), and 20-N, as shown in FIG. 5, wherein N is a natural counting number. In other words, each individual unit cell 20-N is a cascode FET. Although this structure improves stability to some extent, it still may suffer from instability at some frequency ranges, which is mainly caused by parasitic inductances L1 through LN at the gates of the second FETs $Q_2$, $Q_3$, $Q_{i-1}$, $Q_{i-2}$ like the parasitic inductance L1 at the second gate GA2 and a main parasitic inductor ($L_{M1}$) associated with metal that carries voltage to the second gates, like GA2 of $Q_2$, wherein i is a natural counting number and there are two transistors per unit cell. Equivalent inductance of L1 through LN and $L_{M1}$ together with the bypass capacitor $C_{BPY1}$ form a resonator with resonance frequency in desired operating frequency ranges (e.g., 3.5 GHz to 8 GHz for an 8x325 $\mu$m FET periphery). This typically causes unconditional instability in the same frequency range where the cascode FET oscillates.

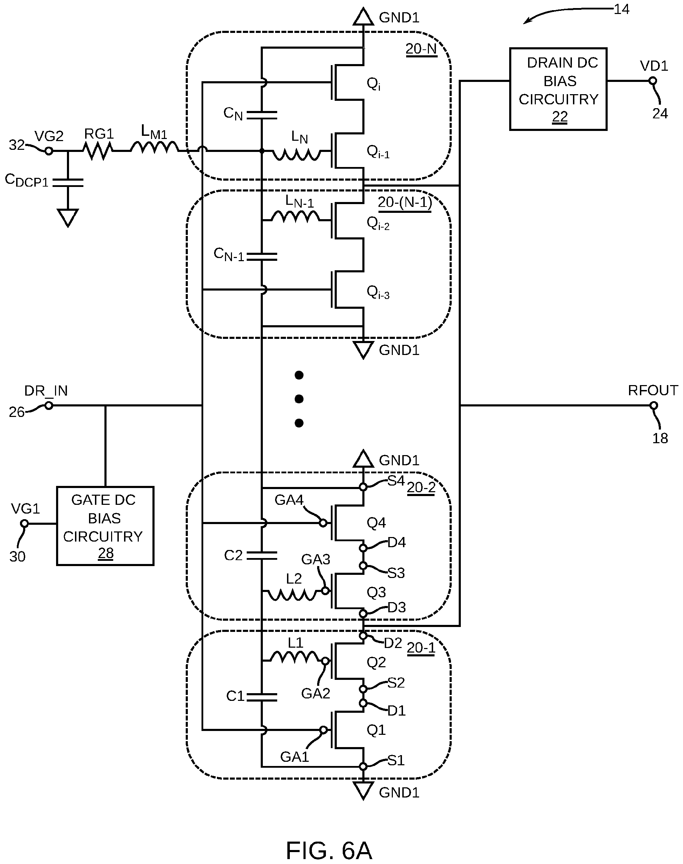

Disclosed is a cascode FET structure and layout to further reduce the parasitic inductance on the second gates, like GA2 of $Q_2$, by moving the bypass capacitor $C_{BPY1}$ substantially closer to the gate of the common gate FET Q2. This configuration is repeated in each of the unit cells 20-1 through 20-N, as shown in FIG. 6A. Each of capacitors C1 through CN is a bypass capacitor for each of the unit cells 20-1 through 20-N. The capacitors C1 through CN each have a capacitance that is less than or equal to the capacitance of the bypass capacitor $C_{BPY1}$ of FIG. 5. In the cascode FET structure, equivalent parasitic inductance between the gate of each common gate FET such the second FET Q2 and bypass capacitance is reduced as $L_{M1}$ is removed. Likewise, each of the capacitors C1 through CN is configured to keep the capacitance minimal while maintaining proper bypass for the RF signal in the desired frequency range. Therefore, the resonance frequency of the N resonant circuits made up of L1 through LN and C1 through CN at gate of each cascode unit cell FET such as the second gate of common gate FET Q2 is shifted to much higher frequencies, which makes the cascode structure stable in a broader frequency range (e.g., up to 8 GHz for an 8x325 $\mu$m FET periphery).

It should be noted that decreasing capacitance of the capacitors C1-CN below an optimized range impacts RF termination at gate of the cascode common gate FETs such as the FET Q2, which results in gate voltage swing during operation and eventually reduces overall gain of the second stage 14 by up to 40% in some applications. On the other hand, increasing capacitance of the capacitors C1 through CN above an optimized range reduces the resonance frequency of circuits made up of L1 through LN and C1 through CN in each of the unit cells 20-1 through 20-N and results in instability in the desired operating frequency range.

Since $L_{M1}$ is coupled to C1 through CN, it forms another resonant circuit made up of $L_{M1}$, $C_{DCP1}$, and the capacitors C1 through CN, which resonates at a frequency much lower than resonance frequency of $L_1 - C_1$, as in unit cell 1, because the inductance of $L_{M1}$ is orders of magnitude greater than the inductance of any of L1 through LN. Typically, this lower resonance will be less than 2 GHz. This can result in an instability issue as gain of the cascode is considerably high at low frequencies. So, a gate resistor $R_{G1}$ added between the bypass capacitances C1 through CN and the decoupling capacitor $C_{DCP1}$. Resistance for the gate resistor $R_{G2}$ is chosen to attenuate the magnitude of resonance and therefore to improve the stability of the cascode FET Q2 at low frequencies.

As mentioned, the capacitors C1 through CN are placed substantially close to the gates of the common gate transistors such as the FET Q2. In one example, a bottom plate of the first capacitor C1 is placed substantially on top of source vias or source pads of the common source FET Q1 to minimize inductance between C1 and the fixed voltage node GND1, which in this case is ground. This configuration is repeated in each of unit cells 20-1 through 20-N. In one example, bypass capacitors, such as C2 and C3, of adjacent unit cells, such as 20-2 and 20-3, that share same source vias or source pads for common source FETs, Q4 and Q6, can be combined into one capacitor. It is important to minimize inductance between source pads of common source FETs, such as Q1, since it has impact on the stability of the second stage 14. This can be achieved by implementing typical methods such as increasing the number of ground vias, via size, or ground pad size.

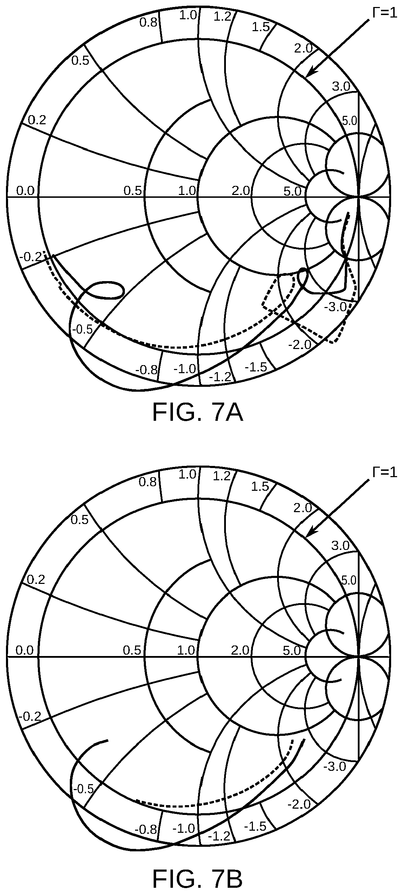

Layouts in FIG. 5 and FIG. 6A are fabricated using GaN technology, and small signal S parameters are measured to compare the stability of two embodiments. The output return loss $S_{22}$ of both embodiments is shown in Smith charts in FIGS. 7A and 7B. The $S_{22}$ of the embodiment shown in FIG. 5 is depicted in solid line. The $S_{22}$ of the embodiment shown in FIG. 6A is depicted in dashed line. An indicator for unconditional instability is $|S_{22}| > 1$. The $|S_{22}|$ of the disclosed layout remains less than 1 up to 8 GHz, whereas for the embodiment in FIG. 5, $|S_{22}|$ is greater than 1 from 4 GHz to 8 GHz. This measurement result shows that the cascode structure using topology in FIG.5 is unconditionally instable from 4 GHz to 8GHz. On the other hand, the cascode structure using disclosed topology in FIG. 6A is unconditionally instable at frequencies greater than 8GHz. It clearly shows the improvement in stability of a cascode power amplifier which is achieved by minimizing parasitic components and optimizing bypass capacitance for each unit cell 20-1 to 20-N.

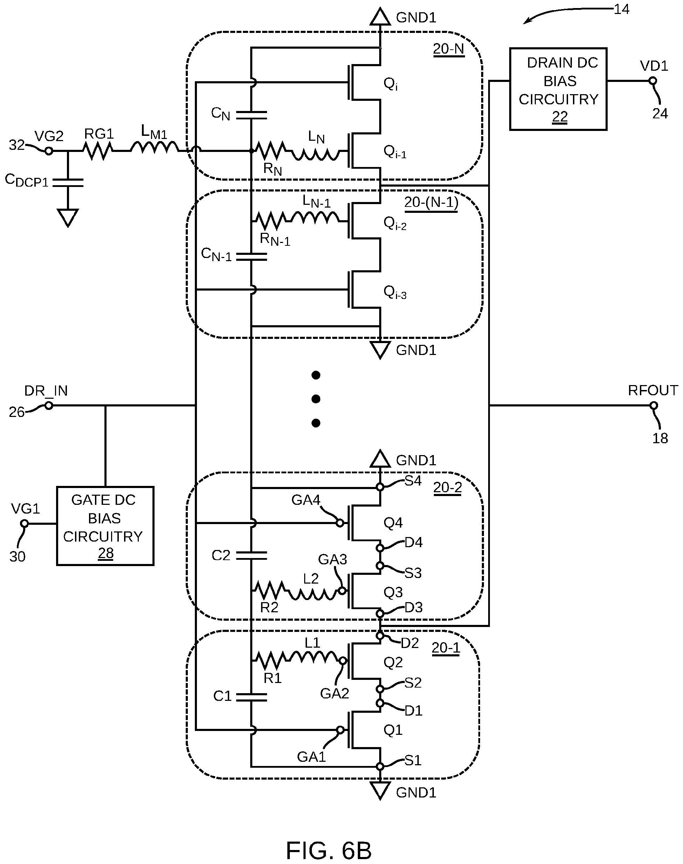

Disclosed is a cascode FET structure and layout to further improve the stability of the cascode in FIG. 6A by adding a resistor between each of the capacitors C1 through CN and the gate of common gate FETs Q2, Q3, ..., $Q_{i-2}$, and $Q_{i-1}$. This configuration is shown in FIG. 6B. A plurality of resistors $R_1$, $R_2$, $R_{N-1}$, and $R_N$ improves the stability of cascode amplifiers as it results in an $|S_{22}|$ less than 1 at frequencies beyond 8 GHz compared with the configuration in FIG. 6A.

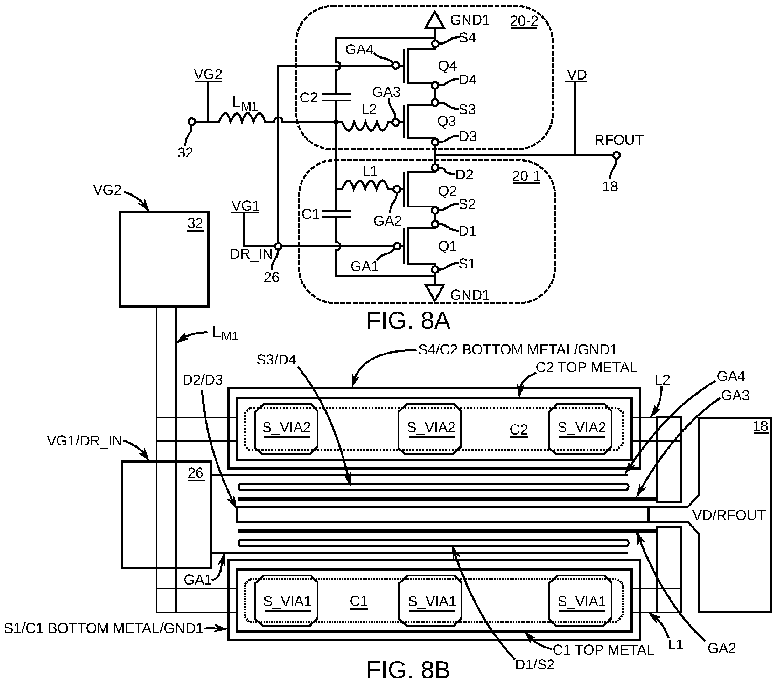

FIG. 8A is a simplified schematic of adjacent unit cells 20-1 and 20-2. FIG. 8B is a layout diagram of the pair of adjacent unit cells 20-1 and 20-2 that are schematically depicted in FIG. 8A. Solid lines in FIG. 8B depict some metallization formed within various layers of the layout. FIG. 8B does not show all metallization, such as all gate layers metallization, for simplicity. Dashed lines depict capacitor areas, and C1 and C2 are formed by two metal layers on the top and bottom of a dielectric layer with a specific dielectric constant. Inductances L1 and L2 are dependent on the length and aspect ratios of the metal that creates the inductances L1 and L2. The inductance values for the inductances L1 and L2 are between 2 picohenries (pH) and 10 pH in some embodiments, while in other embodiments the inductance values for L1 and L2 are between 10 pH and 20 pH. In still other embodiments, the inductance values for L1 and L2 are between 20 pH and 40 pH. The top metal of capacitor C1 is connected to a metal trace that creates L1 and a metal trace that creates LM1. The top metal of capacitor C2 is connected to a metal trace that creates L2 and a metal trace that creates LM1. Three source vias S_VIA1 couple the bottom metal of the first capacitor C1 to a metal plane that is the fixed voltage node GND1, and a same via couples the source pad of the common source FET Q1 to a metal plane that is the fixed voltage node GND1. In other embodiments, one via is used to couple the bottom metal of the first capacitor C1 to a metal plane that is the fixed voltage node GND1. In still other embodiments, two vias are used to couple the bottom metal of the first capacitor C1 to a metal plane that is the fixed voltage node GND1. In still other embodiments, four vias are used to couple the bottom metal of the first capacitor C1 to a metal plane that is the fixed voltage node GND1. Another set of three source vias S_VIA2 couples the bottom metal of the second capacitor C2 to the metal plane that is the fixed voltage node GND1, and a same via couples the source pad of the common source FET Q2 to a metal plane that is the fixed voltage node GND1. In other embodiments, one via is used to couple the bottom metal of the second capacitor C2 to a metal plane that is the fixed voltage node GND1. In still other embodiments, two vias are used to couple the bottom metal of the second capacitor C2 to a metal plane that is the fixed voltage node GND1. In still other embodiments, four vias are used to couple the bottom metal of the second capacitor C2 to a metal plane that is the fixed voltage node GND1. Embodiments of the present disclosure place the metals making up the first inductance L1 and the second inductance L2 substantially close to first capacitor C1 and the second capacitor C2, respectively.

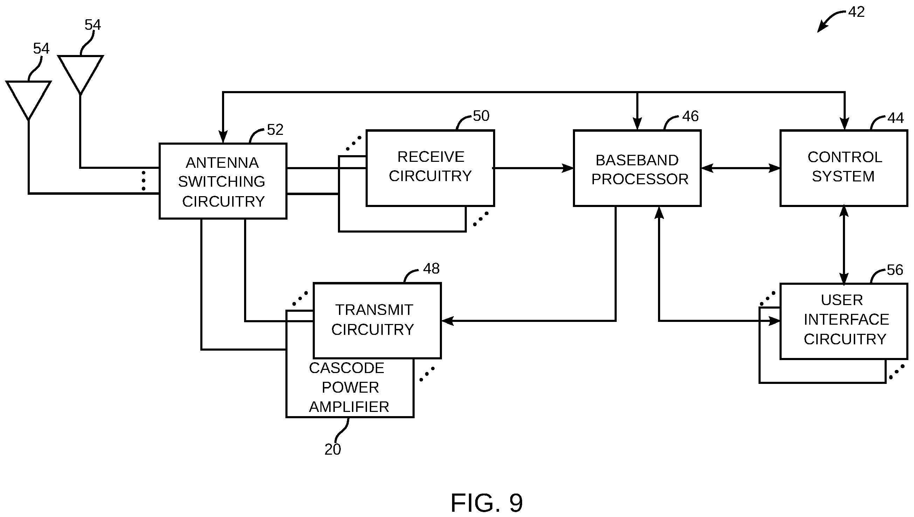

With reference to FIG. 9, the concepts described above may be implemented in various types of wireless communication devices or user elements 42, such as mobile terminals, smart watches, tablets, computers, navigation devices, access points, and the like that support wireless communications, such as cellular, wireless local area network (WLAN), Bluetooth, and near-field communications. The user elements 42 will generally include a control system 44, a baseband processor 46, transmit circuitry 48 that includes the cascode power amplifier 20, receive circuitry 50, antenna switching circuitry 52, multiple antennas 54, and user interface circuitry 56. The receive circuitry 50 receives radio frequency signals via the antennas 54 and through the antenna switching circuitry 52 from one or more basestations or mobile terminals. A low-noise amplifier and a filter (not shown) cooperate to amplify and remove broadband interference from the received signal for processing. Downconversion and digitization circuitry (not shown) then downconvert the filtered, received signal to an intermediate or baseband frequency signal, which is then digitized into one or more digital streams.

The baseband processor 46 processes the digitized received signal to extract the information or data bits conveyed in the received signal. This processing typically comprises demodulation, decoding, and error correction operations. The baseband processor 46 is generally implemented in one or more digital signal processors (DSPs) and application-specific integrated circuits (ASICs).

For transmission, the baseband processor 46 receives digitized data, which may represent voice, data, or control information, from the control system 44, which it encodes for transmission. The encoded data are output to the transmit circuitry 48, where they are used by a modulator (not shown) to modulate a carrier signal that is at a desired transmit frequency or frequencies. A power amplifier (not shown) amplifies the modulated carrier signal to a level appropriate for transmission and delivers the modulated carrier signal to the antennas 54 through the antenna switching circuitry 52. The antennas 54 and the replicated transmit circuitry 48 and receive circuitry 50 may provide spatial diversity. Modulation and processing details will be understood by those skilled in the art.

Therefore, from one perspective, there have been described approaches for a power amplifier cell having a first transistor with a first terminal coupled to ground, a second terminal, and a first control terminal. A second transistor has a third terminal coupled to the second terminal, a fourth terminal, and a second control terminal. Further included is a capacitor having a first plate coupled directly to the second control terminal and a second plate coupled to the ground. As such, there is no intervening inductor component coupled between the first plate and the second control terminal, leaving only parasitic inductance between the first plate and the second control terminal. The capacitor has a capacitance sized to resonate with the parasitic inductance at a resonant frequency substantially higher than a desired frequency of operation of the power amplifier cell.

Further examples are set out in the following numbered clauses.

Clause 1. A power amplifier cell comprising: a first transistor having a first current terminal coupled to a fixed voltage node, a second current terminal, and a first control terminal; a second transistor having a third current terminal coupled to the second current terminal, a fourth current terminal, and a second control terminal; and a capacitor having a first plate coupled directly to the second control terminal and a second plate coupled to the fixed voltage node.

Clause 2. The power amplifier cell of clause 1 wherein there is no intervening inductor component coupled between the first plate and the second control terminal.

Clause 3. The power amplifier cell of clause 1 or 2 wherein there is no intervening resistor component coupled between the first plate and the second control terminal.

Clause 4. The power amplifier cell of clause 1, 2 or 3 wherein inductance between the first plate and the second control terminal is parasitic inductance.

Clause 5. The power amplifier cell of clause 4 wherein the capacitor has capacitance sized to resonate with the parasitic inductance at a resonant frequency substantially higher than a desired frequency of operation of the power amplifier cell.

Clause 6. The power amplifier cell of any of clauses 1 to 5 wherein the fixed voltage node is ground.

Clause 7. A power amplifier comprising a plurality of the power amplifier cells of any of clauses 1 to 6.

Clause 8. The power amplifier of clause 7 wherein the plurality of power amplifier cells comprises a Doherty power amplifier.

Clause 9. The power amplifier of clause 7 or 8 wherein there is no intervening inductor component coupled between the first plate and the second control terminal.

Clause 10. The power amplifier of clause 7, 8 or 9 wherein there is no intervening resistor component coupled between the first plate and the second control terminal.

Clause 11. The power amplifier of any of clauses 7 to 10 wherein inductance between the first plate and the second control terminal is parasitic inductance.

Clause 12. The power amplifier of clause 11 further comprising a resistor coupled between the parasitic inductance and the first plate.

Clause 13. The power amplifier of clause 11 or 12 wherein the capacitor has capacitance sized to resonate with the parasitic inductance at a resonant frequency substantially higher than a desired frequency of operation of the power amplifier cell.

Clause 14. The power amplifier of any of clauses 7 to 13 wherein the fixed voltage node is ground.

Clause 15. The power amplifier of any of clauses 7 to 14 wherein the first transistor and the second transistor are fabricated of gallium nitride technology.

Clause 16. A method of realizing enhanced lineup efficiency in an amplifier having a driver stage configured to drive a final stage, the method comprising: implementing a cascode transistor structure within each of a plurality of power amplifier cells comprising the final stage; and minimizing inductance at a gate of each of a common gate transistor comprising the cascode transistor structure by coupling a bypass capacitor directly between each gate and a fixed voltage node.

Clause 17. The method of realizing enhanced lineup efficiency in an amplifier of clause 16 further comprising sizing capacitance of the bypass capacitor to resonate with a parasitic inductance at a resonant frequency substantially higher than a desired frequency of operation of the amplifier.

Clause 18. The method of realizing enhanced lineup efficiency in the amplifier of clause 16 or 17 wherein the fixed voltage node is ground.

Clause 19. The method of realizing enhanced lineup efficiency in the amplifier of clause 16, 17 or 18 wherein the cascode transistor structure is fabricated of gallium nitride technology.

Clause 20. A wireless communication device comprising: a baseband processor; transmit circuitry configured to receive encoded data from the baseband processor and to modulate a carrier signal with the encoded data, wherein the transmit circuitry comprises: a first transistor having a first current terminal coupled to a fixed voltage node, a second current terminal, and a first control terminal configured to receive the carrier signal; a second transistor having a third current terminal coupled to the second current terminal, a second control terminal, and a fourth current terminal configured to output an amplified version of the carrier signal; and a capacitor having a first plate coupled directly to the second control terminal and a second plate coupled to the fixed voltage node.

Clause 21. The wireless device of clause 20 wherein there is no intervening inductor component coupled between the first plate and the second control terminal.

Clause 22. The wireless device of clause 20 or 21 wherein there is no intervening resistor component coupled between the first plate and the second control terminal.

Clause 23. The wireless device of clause 20, 21 or 22 wherein inductance between the first plate and the second control terminal is parasitic inductance.

Clause 24. The wireless device of clause 23 further comprising a power amplifier comprising a resistor coupled between the parasitic inductance and the first plate.

Clause 25. The wireless of clause 23 or 24 wherein the capacitor has capacitance sized to resonate with the parasitic inductance at a resonant frequency substantially higher than a desired frequency of operation of the power amplifier cell.

Clause 26. The wireless device of any of clauses 20 to 25 wherein the fixed voltage node is ground.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

**Claims**

1. A power amplifier cell comprising:

   • a first transistor having a first current terminal coupled to a fixed voltage node, a second current terminal, and a first control terminal;
   • a second transistor having a third current terminal coupled to the second current terminal, a fourth current terminal, and a second control terminal; and
   • a capacitor having a first plate coupled directly to the second control terminal and a second plate coupled to the fixed voltage node.

2. The power amplifier cell of claim 1 wherein there is no intervening inductor component coupled between the first plate and the second control terminal.

3. The power amplifier cell of claim 1 or 2 wherein there is no intervening resistor component coupled between the first plate and the second control terminal.

4. The power amplifier cell of claim 1, 2 or 3 wherein inductance between the first plate and the second control terminal is parasitic inductance.

5. The power amplifier cell of claim 4 further comprising a resistor coupled between the parasitic inductance and the first plate.

6. The power amplifier cell of claim 4 or 5 wherein the capacitor has capacitance sized to resonate with the parasitic inductance at a resonant frequency substantially higher than a desired frequency of operation of the power amplifier cell.

7. The power amplifier cell of any of claims 1 to 6 wherein the fixed voltage node is ground.

8. The power amplifier cell of any of claims 1 to 7 wherein the first transistor and the second transistor are fabricated of gallium nitride technology

9. A power amplifier comprising a plurality of the power amplifier cells of any of claims 1 to 8.

10. A wireless communication device comprising:

   • a baseband processor;
   • transmit circuitry configured to receive encoded data from the baseband processor and to modulate a carrier signal with the encoded data, wherein the transmit circuitry comprises the power amplifier cell of any of claims 1 to 8, wherein:

      • the first control terminal is configured to receive the carrier signal;
      • the fourth current terminal is configured to output an amplified version of the carrier signal.

11. A method of realizing enhanced lineup efficiency in an amplifier having a driver stage configured to drive a final stage, the method comprising:

   • implementing a cascode transistor structure within each of a plurality of power amplifier cells comprising the final stage; and
   • minimizing inductance at a gate of each of a common gate transistor comprising the cascode transistor structure by coupling a bypass capacitor directly between each gate and a fixed voltage node.

12. The method of realizing enhanced lineup efficiency in an amplifier of claim 11 further comprising sizing capacitance of the bypass capacitor to resonate with a parasitic inductance at a resonant frequency substantially higher than a desired frequency of operation of the amplifier.

13. The method of realizing enhanced lineup efficiency in the amplifier of claim 11 or 12 wherein the fixed voltage node is ground.

14. The method of realizing enhanced lineup efficiency in the amplifier of claim 11, 12 or 13 wherein the cascode transistor structure is fabricated of gallium nitride technology.

GAIN = $G_1$
EFFICIENCY = $\eta_1$

GAIN = $G_2$
EFFICIENCY = $\eta_2$

FIG. 1

13%< $\eta_1$ < 16%,
ADJUSTED FOR GAIN
$\eta_2$ = 55%

FINAL STAGE GAIN [dB]

LINEUP EFFICIENCY [%]

FIG. 2A

$G_2$ = 14dB
$\eta_2$ = 55%

DRIVER STAGE GAIN [dB]

LINEUP EFFICIENCY [%]

FIG. 2B

DRAIN DC
BIAS
CIRCUITRY
22

VD1

24

20

RFOUT

18

D2

VG2

32

LG2

Q2

GA2

S2

$C_{DCP1}$

$C_{BPY1}$

D1

DR_IN

26

Q1

GA1

S1

VG1

30

GATE DC
BIAS
CIRCUITRY
28

GND1

FIG. 3

10

RFIN

16

DRIVER

12

14

MAIN
CASCODE
34

SECOND
DELAY
CIRCUITRY
40

FIRST
DELAY
CIRCUITRY
38

AUX.
CASCODE
36

RFOUT

18

FIG. 4A

10

RFIN

16

DRIVER

12

14

FIRST
DELAY
CIRCUITRY
38

MAIN
CASCODE
34

AUX.
CASCODE
36

SECOND
DELAY
CIRCUITRY
40

RFOUT

18

FIG. 4B

FIG. 5

FIG. 6A

FIG. 6B

FIG. 7A

FIG. 7B

FIG. 8A

FIG. 8B

EP 4 404 458 A1

FIG. 9

Europäisches
Patentamt

European
Patent Office

Office européen
des brevets

# EUROPEAN SEARCH REPORT

**Application Number**

EP 24 15 1466

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/011436 A1 (SHIGEMATSU HISAO [JP]) 16 January 2003 (2003-01-16) * paragraphs [0002] - [0085]; figures 1-11 * | 1-14 | INV. H03F1/22 H03F1/02 H03F1/30 H03F1/56 H03F3/195 H03F3/24 H03F3/21 H03F3/30 |
| X | US 2014/306761 A1 (FUJIWARA SHIGERU [JP] ET AL) 16 October 2014 (2014-10-16) | 1,2,4-14 | |
| A | * paragraphs [0002] - [0043]; figures 1-12 * | 3 | |
| X | US 9 948 252 B1 (ADAMSKI JAROSLAW [US]) 17 April 2018 (2018-04-17) | 1-4,6-14 | |
| A | * column 1, line 41 - column 15, line 9; figures 1-10 * | 5 | |

**TECHNICAL FIELDS SEARCHED (IPC)**

H03F

The present search report has been drawn up for all claims

| Place of search | Date of completion of the search | Examiner |
|---|---|---|
| The Hague | 13 June 2024 | Fedi, Giulio |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
.......................................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 15 1466

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2024

| Patent document cited in search report | | Publication date | Patent family member(s) | | Publication date |
|---|---|---|---|---|---|
| US 2003011436 | A1 | 16-01-2003 | CA | 2376410 A1 | 11-01-2003 |
| | | | EP | 1276230 A2 | 15-01-2003 |
| | | | JP | 4751002 B2 | 17-08-2011 |
| | | | JP | 2003092523 A | 28-03-2003 |
| | | | US | 2003011436 A1 | 16-01-2003 |
| US 2014306761 | A1 | 16-10-2014 | CN | 104113287 A | 22-10-2014 |
| | | | JP | 6201391 B2 | 27-09-2017 |
| | | | JP | 2014209673 A | 06-11-2014 |
| | | | KR | 20140125294 A | 28-10-2014 |
| | | | US | 2014306761 A1 | 16-10-2014 |
| US 9948252 | B1 | 17-04-2018 | CN | 110546882 A | 06-12-2019 |
| | | | EP | 3607654 A1 | 12-02-2020 |
| | | | US | 9948252 B1 | 17-04-2018 |
| | | | US | 2018294782 A1 | 11-10-2018 |
| | | | US | 2020112290 A1 | 09-04-2020 |
| | | | US | 2021159863 A1 | 27-05-2021 |
| | | | US | 2023283247 A1 | 07-09-2023 |
| | | | WO | 2018187248 A1 | 11-10-2018 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 63513974 A
- WO 63479788 A
- WO 63539384 A
- WO 63511352 A
- WO 63502268 A
- WO 63479790 A
- WO 63479787 A